# EUROPÄISCHE PATENTSCHRIFT

(11) **EP 2 625 715 B1**
(45) Veröffentlichungstag und Bekanntmachung des Hinweises auf die Patenterteilung: **07.11.2018**
(21) Anmeldenummer: 11770726.5
(22) Anmeldetag: 30.09.2011
(51) Int. Cl.: H05B 37/02

(54) **LEUCHTVORRICHTUNG MIT MEHREREN VONEINANDER BEABSTANDET EMISSIONSBEREICHE**
LUMINOUS DEVICE COMPRISING MULTIPLE SPACED-APART EMISSION REGIONS
DISPOSITIF LUMINESCENT À PLUSIEURS ZONES D'ÉMISSION ESPACÉES LES UNES DES AUTRES

(30) Priorität: 04.10.2010 DE 102010047450
(43) Veröffentlichungstag der Anmeldung: 14.08.2013
(73) Patentinhaber: OSRAM Opto Semiconductors GmbH, 93055 Regensburg (DE)
(72) Erfinder: HÄFNER, Norbert, 93138 Lappersdorf (DE); BRANDL, Michael, 93098 Mintraching (DE)
(74) Vertreter: Epping - Hermann - Fischer
(86) Internationale Anmeldenummer: PCT/EP2011/067156
(87) Internationale Veröffentlichungsnummer: WO 2012/045684

(56) Entgegenhaltungen:
- WO-A1-2007/071397
- WO-A2-2006/129291
- DE-A1-102004 042 185
- DE-A1-102004 056 705
- US-A1- 2009 152 569
- US-A1- 2009 322 241
- US-A1- 2010 141 175
- US-A1- 2010 163 891

## Beschreibung

Es wird eine Leuchtvorrichtung sowie eine Signalleuchte mit einer solchen Leuchtvorrichtung angegeben.

Eine zu lösende Aufgabe besteht darin, eine Leuchtvorrichtung anzugeben, welche kompakt im Aufbau und einfach herstellbar ist.

Die Druckschrift WO 2007/071397 A1 betrifft eine Beleuchtungsvorrichtung, eine Beleuchtungskontrollapparatur und ein Beleuchtungssystem.

Die Druckschrift US 2010/163891 A1 betrifft eine Licht emittierende Diode.

Die Leuchtvorrichtung umfasst zumindest einen strahlungsemittierenden Halbleiterchip, der zumindest zwei in lateraler Richtung voneinander beabstandet angeordnete Emissionsbereiche aufweist, wobei jeder Emissionsbereich zumindest eine zur Emission von elektromagnetischer Strahlung geeignete aktive Zone umfasst, wobei der strahlungsemittierende Halbleiterchip zumindest einen Träger umfasst, wobei zumindest zwei der Emissionsbereiche auf dem Träger gemeinsam epitaktisch aufgewachsen und befestigt sind, wobei die Emissionsbereiche eine oder mehrere der folgenden Eigenschaften aufweisen: gleiche Ausdehnung in vertikaler Richtung, die gleiche Halbleiterschichtenfolge, eine gleiche Ausdehnung in vertikaler Richtung der einzelnen Halbleiterschichten, eine gleiche Materialzusammensetzung. Die Leuchtvorrichtung umfasst außerdem eine Ansteuervorrichtung zum Betreiben der Emissionsbereiche, wobei die Emissionsbereiche getrennt voneinander elektrisch betreibbar sind, und die Ansteuervorrichtung dazu eingerichtet ist, jeden Emissionsbereich in Abhängigkeit von zumindest einer der folgenden Bedingungen getrennt von den verbleibenden Emissionsbereichen anzusteuern: Betriebsdauer des Emissionsbereichs, vorgebbare Mindestintensität der vom Emissionsbereich emittierten elektromagnetischen Strahlung, Erreichen einer maximalen Betriebstemperatur des Halbleiterchips, Intensität der von dem Halbleiterchip zu emittierenden elektromagnetischen Strahlung, Lichtstärkenverteilung entlang einer Leuchtfläche des strahlungsemittierenden Halbleiterchips, Lichtstärkenverteilung entlang eines von der Leuchtvorrichtung zu beleuchtenden Objekts.

Gemäß zumindest einer Ausführungsform der Leuchtvorrichtung umfasst diese zumindest einen strahlungsemittierenden Halbleiterchip, der zumindest zwei in lateraler Richtung voneinander beabstandet angeordnete Emissionsbereiche aufweist. Jeder der Emissionsbereiche umfasst zumindest eine zur Emission von elektromagnetischer Strahlung geeignete aktive Zone. "Beabstandet angeordnet" heißt in diesem Zusammenhang, dass die Emissionsbereiche nicht ineinander übergehen und/oder miteinander überlappen. Beispielsweise sind die Emissionsbereiche durch eine epitaktisch auf einem Träger, beispielsweise einem Substrat, gewachsene Halbleiterschichtenfolge gebildet. Dabei kann die laterale Richtung eine Richtung parallel zu der epitaktisch gewachsenen Halbleiterschichtenfolge sein. Die Halbleiterschichtenfolge kann in einzelne voneinander beabstandet angeordnete und beispielweise elektrisch voneinander isolierte Emissionsbereiche unterteilt sein. Zum Beispiel ist in der lateralen Richtung zwischen jeweils benachbarten Emissionsbereichen zumindest ein Zwischenbereich ausgebildet. Der Zwischenbereich kann in einer Draufsicht auf den Halbleiterchip durch Seitenflächen der Emissionsbereiche sowie eine den Emissionsbereichen zugewandte Oberfläche des Trägers begrenzt sein. Mit anderen Worten grenzen die aktiven Zonen der Emissionsbereiche in lateraler Richtung nicht direkt aneinander an, sondern sind durch die Zwischenbereiche voneinander getrennt.

Unter externer Kontaktierung der aktiven Zonen emittiert diese elektromagnetische Strahlung in einem Wellenbereich innerhalb des ultravioletten bis infraroten Spektralbereichs der elektromagnetischen Strahlung. Vorzugsweise emittieren die aktiven Zonen des strahlungsemittierenden Halbleiterchips Licht im sichtbaren oder ultravioletten Bereich des Spektrums der elektromagnetischen Strahlung. Beispielsweise ist der strahlungsemittierende Halbleiterchip zur elektrischen Kontaktierung auf einen Kontaktträger aufgebracht. Beispielsweise handelt es sich bei dem Kontaktträger um eine metallische Platte (auch Leadframe), eine Leiterplatte oder um einen Keramikträger.

Gemäß zumindest einer Ausführungsform umfasst die Leuchtvorrichtung eine Ansteuervorrichtung zum Betreiben der Emissionsbereiche. "Betreiben" heißt in diesem Zusammenhang, dass die Ansteuervorrichtung beispielsweise mittels Beaufschlagen mit elektrischem Strom, die Emissionsbereiche vorgebbar bestromen und/oder vorgebbar mit einer Betriebsspannung belegen kann, so dass diese elektromagnetische Strahlung emittieren.

Gemäß zumindest einer Ausführungsform sind die Emissionsbereiche getrennt voneinander elektrisch betreibbar. Das kann heißen, dass unabhängig voneinander in die einzelnen Emissionsbereiche Strom einer vorgebbaren Stärke eingeprägt werden kann. Ebenso kann "getrennt voneinander elektrisch betreibbar" heißen, dass die zumindest zwei voneinander beabstandet angeordneten Emissionsbereiche in Bezug auf ihre Betriebsspannung, Betriebstemperatur und/oder Betriebsdauer vorgebbar einstellbar und/oder steuerbar sind.

Gemäß zumindest einer Ausführungsform ist die Ansteuervorrichtung dazu eingerichtet, jeden Emissionsbereich in Abhängigkeit von zumindest einer der Bedingungen Betriebsdauer des Emissionsbereichs, vorgebbare Mindestintensität der vom Emissionsbereich emittierten elektromagnetischen Strahlung, Erreichen einer maximalen Betriebsdauer des Halbleiterchips, Intensität der von dem Halbleiterchip zu emittierenden elektromagnetischen Strahlung, Lichtstärkenverteilung entlang einer Leuchtfläche des strahlungsemittierenden Halbleiterchips, Lichtstärkenverteilung entlang eines von der Leuchtvorrichtung zu beleuchtenden Objekts getrennt von den verbleibenden Emissionsbereichen anzusteuern. Insbesondere kann das heißen, dass die Ansteuervorrichtung dazu eingerichtet ist, den Emissionsbereich in Abhängigkeit der genannten Bedingungen getrennt von den verbleibenden Emissionsbereichen elektrisch zu betreiben. Die "Leuchtfläche" ist beispielsweise eine dem Träger abgewandte Außenfläche zumindest einer der Emissionsbereiche über die zumindest teilweise innerhalb des Halbleiterchips erzeugte elektromagnetische Strahlung den Halbleiterchip verlässt.

Die hier beschriebene Leuchtvorrichtung beruht dabei unter anderem auf der Erkenntnis, dass eine Einstellung und/oder Modulierung einer von einem strahlungsemittierenden Halbleiterchip erzeugten Strahlungsintensität innerhalb einer Leuchtvorrichtung nur mit hohem Aufwand möglich ist. Zur Einstellung der Strahlungsintensität kann der Halbleiterchip mit unterschiedlichen Bestromungshöhen betrieben werden. Dies kann jedoch mit Schwankungen in der Strahlungsintensität und/oder im Farbort der vom Halbleiterchip emittierten elektromagnetischen Strahlung während des Betriebs der Leuchtvorrichtung verbunden sein. Weiter kann eine derartige Variation in der Bestomungshöhe mit einer Nichtlinearität zwischen der Bestromungshöhe und der Betriebsspannung während des Betriebs einhergehen. Alternativ oder zusätzlich kann der strahlungsemittierende Halbleiterchip mittels eines Pulsweitenmodulierungssignals (auch PWM-Signal) angesteuert und der Halbleiterchip daher in schnellem Wechsel an- und ausgeschaltet werden, um eine geringere Strahlungsintensität erzeugen zu können. Diese Art der Ansteuerung des strahlungsemittierenden Halbleiterchips benötigt jedoch zusätzliche elektronische Bauteile zur Erzeugung des Pulsweitenmodulierungssignals innerhalb der Leuchtvorrichtung.

Sollen andererseits hohe Strahlungsintensitäten von dem Halbleiterchip erzeugt werden, können damit einhergehende hohe Ströme elektromagnetische Störungen innerhalb des Halbleiterchips oder innerhalb der elektronischen Bauteile der Leuchtvorrichtung hervorrufen, die durch zusätzliche Bauelemente innerhalb der Leuchtvorrichtung unterdrückt oder vermieden werden können. Solche zusätzlichen Bauelemente können jedoch hohe Herstellungskosten verursachen und zu einer Leuchtvorrichtung führen, die wenig kompakt im Aufbau ist.

Umfasst die Leuchtvorrichtung zur Einstellung der Strahlungsintensität zumindest zwei strahlungsemittierende Halbleiterchips, können diese mit jeweils unterschiedlichen Bestromungshöhen betrieben werden. Zwar ist ein derartiges Betreiben der Halbleiterchips kostengünstig, jedoch stellt dies enge, vorher festgelegte Spezifikationsanforderungen an die jeweiligen Halbleiterchips. Eine derartige Vorselektion an geeigneten strahlungsemittierenden Halbleiterchips kann zusätzliche Kosten in der Herstellung der Leuchtvorrichtung verursachen. Auch in diesem Fall kann die Leuchtvorrichtung wenig kompakt sein, da für jeden der strahlungsemittierenden Halbleiterchips beispielsweise eine eigene Bestromung beziehungsweise Bestromungszufuhr gesucht werden muss.

Um nun eine Leuchtvorrichtung anzugeben, welche zum einen kostengünstig herstellbar ist und zum anderen einfach und kompakt im Aufbau ist, macht die hier beschriebene Leuchtvorrichtung unter anderem von der Idee Gebrauch, zumindest einen strahlungsemittierenden Halbleiterchip bereitzustellen, der zumindest zwei in lateraler Richtung voneinander beabstandet angeordnete Emissionsbereiche aufweist. Mit anderen Worten ist der oben beschriebene strahlungsemittierende Halbleiterchip in zumindest zwei Emissionsbereiche unterteilt, wobei jeder der Emissionsbereiche durch die gemeinsame Ansteuervorrichtung der Leuchtvorrichtung betrieben und angesteuert werden kann. Das heißt, dass mittels der Ansteuervorrichtung, also mit minimalem Aufwand, die Strahlungsintensität der Leuchtvorrichtung mittels der Bestromung der einzelnen Emissionsbereiche individuell den erforderlichen Bedürfnissen des Benutzers angepasst und eingestellt werden kann. Nicht geeignete und/oder nicht benötigte Emissionsbereiche werden durch die Ansteuerschaltung beispielsweise nicht betrieben. Daher ist keine enge Selektion der einzelnen Emissionsbereiche beispielsweise im Hinblick auf ihren emittierten Farbort erforderlich. Vorteilhaft ist eine derartige Leuchtvorrichtung kostengünstig in der Herstellung sowie einfach und kompakt im Aufbau.

Gemäß zumindest einer Ausführungsform umfasst der strahlungsemittierende Halbleiterchip den Träger, wobei zumindest zwei der Emissionsbereiche gemeinsam epitaktisch aufgewachsen und auf dem Träger befestigt sind.
Bei dem Träger kann es sich beispielsweise um ein Aufwachssubrat handeln, auf dem zumindest zwei der Emissionsbereiche gemeinsam epitaktisch aufgewachsen sind. Der Träger kann beispielsweise auch ein Trägersubstrat ausbilden, auf dem zumindest zwei der gemeinsam auf einem Aufwachssubstrat epitaktisch aufgewachsene Emissionsbereiche befestigt sind. "Gemeinsam" bedeutet im vorliegenden Zusammenhang, dass zumindest zwei der Emissionsbereiche zeitgleich und in zumindest einen Verfahrensschritt aufgewachsen beziehungsweise befestigt werden, wobei die Emissionsbereiche sich den Träger in Form eines Aufwachssubstrats oder Trägersubstrats teilen. Mit anderen Worten bilden sich zumindest zwei der Emissionsbereiche auf dem Träger aus, wobei die einzelnen Emissionsbereiche auch erst nach dem epitaktischen Aufwachsen gebildet werden können. Falls die Leuchtvorrichtung mehrere Träger umfasst, so sind auf mindestens einem der Träger zumindest zwei der Emissionsbereiche in lateraler Richtung nebeneinander angeordnet.

Gemäß zumindest einer Ausführungsform bilden zumindest zwei der Emissionsbereiche in lateraler Richtung eine gemeinsame Grenzfläche aus. Das kann bedeuten, dass sich die Emissionsbereiche in lateraler Richtung berühren, aneinander stoßen oder zusammenhängen.

Gemäß zumindest einer Ausführungsform sind die aktiven Zonen der Emissionsbereiche voneinander getrennt und die Emissionsbereiche stehen nicht im direkten Kontakt.

Gemäß zumindest einer Ausführungsform beträgt der laterale Abstand zwischen zumindest zwei der Emissionsbereichen bevorzugt weiniger als 2,5% oder weniger als 5% oder weniger als 10% der mittleren lateralen Ausdehnung des einzelnen Emissionsbereichs. Das heißt, dass der Abstand zwischen zwei Emissionsbereichen klein im Vergleich zu den lateralen Ausdehnungen des Emissionsbereiches ist.

Aufgrund des gemeinsamen Aufwachsens können die Emissionsbereiche insbesondere eine gleiche Ausdehnung in vertikaler Richtung, die gleiche Halbleiterschichtenfolge, eine gleiche Ausdehnung in vertikaler Richtung der einzelnen Halbleiterschichten und/oder gleiche Materialzusammensetzung aufweisen.

Die vertikale Richtung verläuft dabei zum Beispiel parallel zu einer Wachstumsrichtung der epitaktisch gewachsenen Halbleiterschichten des strahlungsemittierenden Halbleiterchips.

Gemäß zumindest einer Ausführungsform ist die Ansteuervorrichtung dazu eingerichtet, ein nach Erreichen zumindest einer der Bedingungen für einen von der Ansteuervorrichtung betriebenen Emissionsbereich, den Emissionsbereich zu dimmen oder zu deaktivieren. "Dimmen" heißt in diesem Zusammenhang, dass der Emissionsbereich nach Erreichen zumindest einer der Bedingungen beispielsweise mit einer geringeren Strom- und/oder Betriebsspannung weiter betrieben wird. Mit anderen Worten ist die vom dem gedimmten Emissionsbereich emittierte Strahlungsintensität reduziert. Denkbar ist, dass zumindest einer der Emissionsbereiche während des Betriebs der Leuchtvorrichtung eine vorgebbare Betriebstemperatur überschreitet. Beispielsweise kann ein derart überhitzter Emissionsbereich durch die Ansteuervorrichtung durch Verringern einer Bestromungs-und/oder Betriebsspannung, also durch dimmen, vor einem Überhitzen geschützt werden. Vorteilhaft kann bei einem derartigen Emissionsbereich eine Verlustleistung bei Erreichen der maximalen Betriebstemperatur reduziert werden, um damit den Emissionsbereich selbst und beispielsweise ebenso den strahlungsemittierenden Halbleiterchip vor Zerstörung zu schützen.

"Deaktivieren" kann heißen, dass durch die Ansteuervorrichtung eine elektrisch leitende Verbindung zwischen einer externen Energiequelle und dem Emissionsbereich nach Erreichen zumindest einer der Bedingungen unterbrochen wird. In deaktivierte Emissionsbereiche wird während des Betriebs der Leuchtvorrichtung kein Strom mehr eingeprägt. Deaktivierte Emissionsbereiche werden daher auch nicht mehr betrieben. Beispielsweise können während des Betriebs der Leuchtvorrichtung bereits verbrauchte Emissionsbereiche die optische Ausgangsleistung der Leuchtvorrichtung verringern. "Verbrauchte Emissionsbereiche" heißt in diesem Zusammenhang, dass solche Emissionsbereiche nach einer gewissen Betriebsdauer nicht mehr die an sie angelegten Rahmenspezifikationen, wie zum Beispiel der Intensität des abgestrahlten Lichts, erfüllen. Durch Deaktivieren des verbrauchten Emissionsbereichs werden negative Effekte, beispielsweise im Hinblick auf die optische Ausgangsleistung und/oder die Betriebsstabilität der Leuchtvorrichtung, verhindert, obwohl der Emissionsbereich über die gesamte Betriebsdauer angeschlossen bleiben kann.

Gemäß zumindest einer Ausführungsform ist die Zahl der sich im Betrieb befindlichen Emissionsbereiche während des Betriebs der Leuchtvorrichtung konstant. Zum Beispiel kann ein Emissionsbereich, der seine Lebensdauer überschritten hat, durch die Ansteuervorrichtung deaktiviert werden und stattdessen ein bisher noch nicht betriebener Emissionsbereich betrieben werden. Vorteilhaft kann die vom Halbleiterchip emittierte Strahlungsintensität über den gesamten Betriebszeitraum konstant gehalten werden.

Gemäß zumindest einer Ausführungsform wird bei Unterschreiten einer Mindestintensität der vom Halbleiterchip emittierten elektromagnetischen Strahlung zumindest ein Emissionsbereich hinzugeschaltet. Beispielsweise werden zu Beginn des Betriebs der Leuchtvorrichtung für Beleuchtungszwecke nicht alle Emissionsbereiche benötigt. Das heißt, dass zu Beginn des Betriebs der Leuchtvorrichtung durch die Ansteuervorrichtung nur eine bestimmte Anzahl an Emissionsbereichen betrieben werden. Die bisher nicht benutzten und damit bisher nicht betriebenen Emissionsbereiche können beispielsweise nach Ablauf der Lebensdauer eines bereits zu Beginn betriebenen Emissionsbereichs derart hinzugeschaltet werden, dass die Intensität der vom strahlungsemittierenden Halbleiterchip zu emittierenden elektromagnetischen Strahlung nicht unter einen vorgebbaren Wert fällt. Mit anderen Worten kann ein Hinzuschalten von noch nicht benutzten Emissionsbereichen einem Abfall der von dem strahlungsemittierenden Halbleiterchip emittierten Intensität unter einen Grenzwert entgegengewirkt werden.

Gemäß zumindest einer Ausführungsform wird die vom Halbleiterchip emittierte Intensität während des Betriebs der Leuchtvorrichtung durch die Ansteuervorrichtung konstant gehalten. Auch hierbei ist denkbar, dass zu Beginn des Betriebs der Leuchtvorrichtung nicht alle Emissionsbereiche betrieben werden. Noch nicht betriebene Emissionsbereiche können in Abhängigkeit der während des Betriebs der Emissionsbereiche abnehmenden Strahlungsintensitäten schrittweise hinzugeschaltet werden. Für einen externen Betrachter kann sich somit der Eindruck eines konstanten Helligkeits- und/oder Leuchtbilds der Leuchtvorrichtung im Fernfeld ergeben. Damit können die an die Leuchtvorrichtung angelegten Betriebskriterien über einen möglichst langen Zeitraum konstant gehalten werden, wodurch die Lebensdauer der Leuchtvorrichtung signifikant gesteigert ist.

Gemäß zumindest einer Ausführungsform ist zumindest ein Emissionsbereich von den übrigen Emissionsbereichen zumindest stellenweise umrandet, wobei in einem ersten Betriebsmodus der Leuchtvorrichtung nur der umrandete Emissionsbereich von der Ansteuervorrichtung betrieben wird und in einem zweiten Betriebsmodus zumindest einer der übrigen Emissionsbereiche betrieben wird. "Betriebsmodus" heißt in diesem Zusammenhang ein von außen vorgebbares Betreiben der Emissionsbereiche durch die Ansteuervorrichtung, beispielsweise im Hinblick auf die Betriebsparameter Bestromungshöhe, Betriebsspannung, Betriebsdauer und/oder Betriebstemperatur. Der erste Betriebsmodus unterscheidet sich von dem zweiten Betriebsmodus in zumindest einem der genannten Betriebsparameter. Während einer vorgebbaren Betriebsperiode, das heißt einer vorgebbaren Zeitspanne eines Betriebsmodus, können die Betriebsparameter, mit dem die Leuchtvorrichtung betrieben werden, unverändert sein. Dabei können der erste und der zweite Betriebsmodus zu einem vorgebbaren Zeitpunkt, beispielsweise durch plötzliches Umspringen oder in Abhängigkeit eines vorgebbaren Zeitintervalls, zum Beispiel kontinuierlich oder schrittweise ineinander übergehen.

Gemäß zumindest einer Ausführungsform werden im zweiten Betriebsmodus nur die übrigen Emissionsbereiche von der Ansteuervorrichtung betrieben. Das heißt, dass der umrandete Emissionsbereich nicht von der Ansteuervorrichtung im zweiten Betriebsmodus von der Ansteuervorrichtung nicht betrieben wird. In den umrandeten Emissionsbereich wird dann, beispielsweise bis auf Leckströme, kein Strom eingeprägt.

Gemäß zumindest einer Ausführungsform werden im zweiten Betriebsmodus alle Emissionsbereiche von der Ansteuervorrichtung betrieben. Das heißt, dass im zweiten Betriebsmodus in alle Emissionsbereiche Strom einer durch die Ansteuervorrichtung jeweils vorgebbarer Höhe eingeprägt wird.

Gemäß zumindest einer Ausführungsform ist die Intensität der von dem Halbleiterchip emittierten elektromagnetischen Strahlung im zweiten Betriebsmodus wenigstens fünf Mal und höchstens fünfzehn Mal, vorzugsweise wenigstens sieben und höchstens zwölf Mal, so hoch wie im ersten Betriebsmodus.

Gemäß zumindest einer Ausführungsform ist die Intensität der von dem Halbleiterchip emittierten elektromagnetischen Strahlung im ersten Betriebsmodus wenigstens fünf Mal und höchstens fünfzehn Mal, bevorzugt wenigstens sieben und höchstens dreizehn Mal, so hoch wie im zweiten Betriebsmodus.

Gemäß zumindest einer Ausführungsform schaltet die Ansteuervorrichtung bei Unterschreiten einer Umgebungshelligkeit der Leuchtvorrichtung zumindest einen Emissionsbereich hinzu oder schaltet bei Überschreiten einer Umgebungshelligkeit der Leuchtvorrichtung zumindest einen Emissionsbereich ab. Beispielsweise weist die Leuchtvorrichtung einen Helligkeitssensor auf, der eine die Leuchtvorrichtung umgebene Umgebungshelligkeit misst und diese Messdaten an die Ansteuervorrichtung, nach entsprechend analoger und/oder digitaler Umwandlung, an die Ansteuervorrichtung, übermittelt und aufgrund dieser Messdaten die Ansteuervorrichtung zumindest einen Emissionsbereich hinzuschaltet oder abschaltet. Eine derartige Leuchtvorrichtung kann beispielsweise in Straßenlaternen verbaut sein, welche während abnehmender Tageshelligkeit beginnt durch Hinzuschalten zumindest eines Emissionsbereichs immer stärker strahlen und umgekehrt bei wieder zunehmender Tageshelligkeit beginnt immer weniger zu strahlen. Durch das Zuschalten und Abschalten von Emissionsbereichen ist allgemein ein besonders einfaches Dimmen realisiert, ohne dass eine Pulsweitenmodulierungsschaltung notwendig ist.

Es wird darüber hinaus eine Signalleuchte angegeben.

Gemäß zumindest einer Ausführungsform umfasst die Signalleuchte zumindest eine Leuchtvorrichtung, wie sie in einer oder mehreren der hier beschriebenen Ausführungsformen beschrieben ist. Das heißt, die für die hier beschriebene Leuchtvorrichtung aufgeführten Merkmale sind auch für die hier beschriebene Signalleuchte offenbart.

Gemäß zumindest einer Ausführungsform umfasst die Signalleuchte zumindest eine Projektionsfläche, auf welche die aus der Leuchtvorrichtung ausgekoppelte elektromagnetische Strahlung trifft. Zum Beispiel handelt es sich bei der Projektionsfläche um einen zumindest teilweise strahlungsdurchlässigen Schirm. Beispielsweise ist dieser Schirm in eine Reflexions- und/oder Strahlungsauskoppeleinrichtung der Signalleuchte integriert. Aus der Leuchtvorrichtung ausgekoppeltes Licht kann auf die Projektionsfläche treffen und von dieser zumindest teilweise aus der Signalleuchte ausgekoppelt werden.

Zum Beispiel ist die Signalleuchte ein Kfz-Scheinwerfer oder ist in einem Kfz-Scheinwerfer verbaut. Bei dem Kfz-Scheinwerfer kann es sich um ein Tagfahrlicht handeln, welches tagsüber, also zum Beispiel im ersten Betriebsmodus, eine beispielweise zehnfach höhere Intensität abstrahlt als bei Nacht, also im zweiten Betriebsmodus. Weiter kann es sich bei dem Kfz-Scheinwerfer um eine Umrissleuchte (auch Positionslicht) des Kfzs handeln.

Ebenso kann die Signalleuchte ein Kfz-Rücklicht sein oder in einem Kfz-Rücklicht verbaut sein. Zum Beispiel erhöht sich die von der Leuchtvorrichtung abgestrahlte Intensität der elektromagnetischen Strahlung beim Bremsen des Kfzs um ein Vielfaches, beispielsweise das Zehnfache. Insofern kann das Bremsen den zweiten Betriebsmodus der Leuchtvorrichtung und die freie Fahrt des Kfzs, das heißt ohne Bremsbetätigung, den ersten Betriebsmodus der Leuchtvorrichtung darstellen. Beispielsweise kann mit dem zweiten Betriebsmodus auch die Stärke des Bremsvorgangs ausgedrückt werden. Vorstellbar ist, dass der zweite Betriebsmodus dann einer Notbremsung des Kfz's entspricht oder die Leuchtvorrichtung umso heller leuchtet, je weiter das Bremspedal durchgedrückt wird.

Ebenso ist denkbar, dass die Signalleuchte eine Hintergrundbeleuchtung beispielsweise für LCD-Anzeigen ist, die in Abhängigkeit der Umgebungshelligkeit die LCD-Anzeige bei Tag mit hoher Intensität und bei Nacht mit geringer Intensität oder umgekehrt hinterleuchtet. "Hohe Intensität" kann heißen, dass in einem ersten Betriebsmodus nur die einen Emissionsbereich umrandenden Emissionsbereiche von der Ansteuervorrichtung betrieben werden und bei Dunkelheit, also in dem zweiten Betriebsmodus, nur der umrandete Emissionsbereich von der Ansteuervorrichtung betrieben wird.

Weiter kann die Signalleuchte ein Leselicht sein oder in einem Leselicht verbaut sein. Falls die Signalleuchte in einem Kfz verbaut ist, ist die von einer dem Leselicht emittierte Intensität der elektromagnetischen Strahlung auch bei schwankender Kfz-Batteriespannung des Fahrzeugs konstant. Beispielsweise wird in Abhängigkeit der Batteriespannung des Kfzs durch die Ansteuervorrichtung zumindest ein Emissionsbereich hinzugeschaltet oder beispielsweise gedimmt. Mit anderen Worten kann die Ansteuervorrichtung eine schwankende Batteriespannung ausgleichen.

Ebenso eignet sich die Signalleuchte als eine Fluchtwegbeleuchtung, die im Normalfall den Fluchtweg nur markiert, bei der also in dem ersten Betriebsmodus der Leuchtvorrichtung nur der umrandete Emissionsbereich von der Ansteuervorrichtung betrieben wird, und bei Notfällen die Leuchtintensität bis zu einer Notbeleuchtung gesteigert wird, was dem zweiten Betriebsmodus der Leuchtvorrichtung entsprechen kann. In dem zweiten Betriebsmodus können beispielsweise alle Emissionsbereiche von der Ansteuervorrichtung betrieben werden.

Ist die Leuchtvorrichtung zum Beispiel in einem Scheinwerfer mit einem Reflektor verbaut, ist es möglich, durch unterschiedlich starke Betriebsspannungen zum Betreiben der einzelnen Emissionsbereiche, das heißt bei unterschiedlich starker Ansteuerung der Emissionsbereiche, Emissionsbilder der Leuchtvorrichtung zu homogenisieren, die ansonsten aufgrund von Fertigungstoleranzen des Reflektors eines solchen Scheinwerfers inhomogen erscheinen würden.

Ebenso kann die Leuchtvorrichtung in Beleuchtungsanwendungen für Bildaufnahmen Verwendung finden, da durch gezielte Ansteuerung der Emissionsbereiche durch die Ansteuervorrichtung eine geeignete Ausleuchtung bis hin zu einer Akzentuierung verschiedener Bereiche erreicht werden kann.

Weiter können von der Ansteuervorrichtung einzeln betriebene Emissionsbereiche einzelne Bereiche eines Reflektors, beispielsweise der hier beschriebenen Projektionsfläche der Signalleuchte, beleuchten, um ein zeitlich veränderbares Leuchtbild, wie es beim Abbiegelicht entsteht, zu erzeugen.

Ferner ist denkbar, dass in dem ersten Betriebsmodus die Leuchtvorrichtung eine Ambientebeleuchtung, zum Beispiel während des Fluges im Flugzeug, ist und in einem zweiten Betriebsmodus, beispielsweise beim Ein- und Aussteigen aus dem Flugzeug, eine Ein- und/oder Ausstiegsbeleuchtung ist.

Im Folgenden wird die hier beschriebene Leuchtvorrichtung sowie die hier beschriebene Signalleuchte anhand von Ausführungsbeispielen und den dazugehörigen Figuren näher erläutert.
- Die Figur 1: zeigt in einer schematischen Draufsicht ein Ausführungsbeispiel einer hier beschriebenen Leuchtvorrichtung.
- Die Figuren 2a bis 4d: zeigen in schematischen Draufsichten einzelne Ausführungsbeispiele eines hier beschriebenen strahlungsemittierenden Halbleiterchips.
- Die Figur 5: zeigt in einer schematischen Schnittansicht ein Ausführungsbeispiel eines hier beschriebenen Halbleiterchips.
- Die Figur 6: zeigt in einem schematischen I-T-Diagramm verschiedene Betriebsmodi der Leuchtvorrichtung.
- Die Figuren 7A und 7B: zeigen in schematischen Ansichten ein Ausführungsbeispiel einer hier beschriebenen Signalleuchte.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

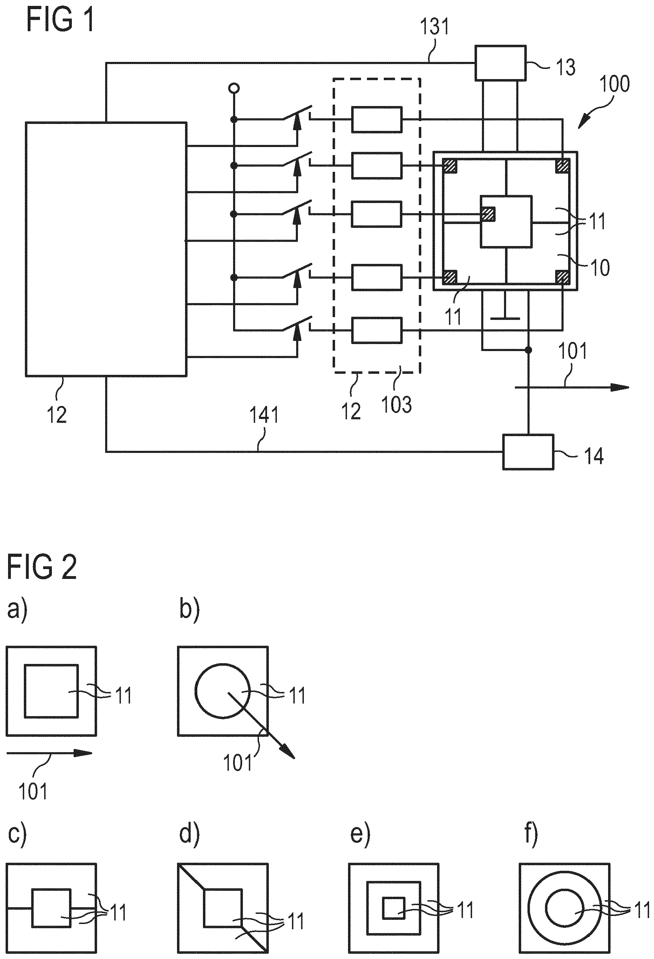

In der Figur 1 ist anhand einer schematischen Draufsicht eine hier beschriebene Leuchtvorrichtung 100 mit einem strahlungsemittierenden Halbleiterchip 10 sowie einer Ansteuervorrichtung 12 dargestellt. Der strahlungsemittierende Halbleiterchip 10 weist insgesamt fünf Emissionsbereiche 11 auf, die in lateraler Richtung 101 voneinander beabstandet angeordnet sind. Die laterale Richtung 101 ist eine Richtung parallel zur Haupterstreckungsrichtung des Halbleiterchips 10. Dabei ist die laterale Richtung 101 abhängig vom gewählten Bezugssystem innerhalb des Halbleiterchips 10. Beispielsweise ist die laterale Richtung 101 eine Richtung in der Haupterstreckungsebene des Halbleiterchips, welche den Halbleiterchip 10 umläuft. Weist der Halbleiterchip 10 kreisförmige Emissionsbereiche 11 auf, kann die laterale Richtung 101 eine Richtung in der Haupterstreckungsebene des Halbleiterchips 100 parallel zu den Durchmessern der einzelnen Emissionsbereiche 11 sein.

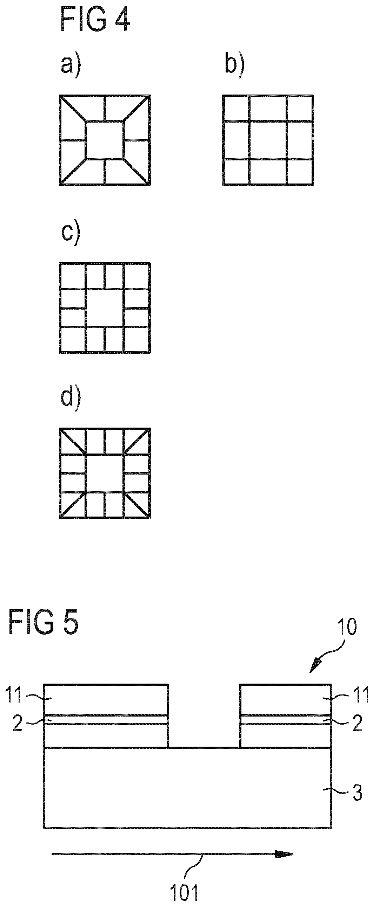

Jeder der Emissionsbereiche 11 umfasst zumindest eine zur Emission von elektromagnetischer Strahlung geeignete aktive Zone 2 (nicht gezeigt, siehe Figur 5). Die Ansteuervorrichtung 12 betreibt jeden der Emissionsbereiche 11 getrennt von den verbleibenden Emissionsbereichen 11 im Hinblick auf die Betriebsdauer des Emissionsbereiches 11, vorgebbare Mindestintensität der vom Emissionsbereich 11 emittierten elektromagnetischen Strahlung, einem Erreichen einer maximalen Betriebsdauer des Halbleiterchips 10, einer Intensität der von dem Halbleiterchip 10 zu emittierenden elektromagnetischen Strahlung, einer Lichtstärkenverteilung entlang einer Leuchtfläche des strahlungsemittierenden Halbleiterchips 10, einer Lichtstärkenverteilung eines von der Leuchtvorrichtung 100 zu beleuchtenden Objekts. Die Zahl der sich im Betrieb befindlichen Emissionsbereiche 11 ist während des Betriebs der Leuchtvorrichtung 100 konstant, wobei bei Unterschreiten einer Mindestintensität der von dem Halbleiterchip 10 zu emittierenden elektromagnetischen Strahlung zumindest ein Emissionsbereich 11 hinzugeschaltet wird. Dazu deaktiviert die Ansteuervorrichtung 12 den jeweils verbrauchten Emissionsbereich 11, wobei der hinzugeschaltete Emissionsbereich 11 den verbrauchten Emissionsbereich 11 ersetzt.

Weiter umfasst die Ansteuervorrichtung 12 eine Vorwiderstandsbeschaltung 103. Mittels der Vorwiderstandsbeschaltung 103 kann eine variable und/oder schwankende externe Betriebsspannung ausgeglichen werden, sodass spezifische Betriebsparameter und Anforderungen an die Leuchtvorrichtung 100 eingehalten werden können und über die gesamte Betriebsdauer eine möglichst konstante Intensität der von dem Halbleiterchip 10 emittierten elektromagnetischen Strahlung sichergestellt ist.

Zudem umfasst die Leuchtvorrichtung 100 zumindest einen Helligkeitssensor 13 und/oder zumindest einen Temperatursensor 14. Zum Beispiel sind der Helligkeitssensor 13 und der Temperatursensor 14 von der Ansteuervorrichtung 12 selbst umfasst oder getrennt von Ansteuervorrichtung 12 innerhalb der Leuchtvorrichtung 100 angeordnet.

Der Helligkeitssensor 13 misst die Umgebungshelligkeit der Leuchtvorrichtung 100. Nach einer analogen und/oder digitalen Umwandlung der von dem Helligkeitssensor 13 gemessenen Helligkeitsmesswerte werden diese an die Ansteuervorrichtung 12 mittels einer Übertragungsleitung 131 übermittelt. Zum Beispiel schaltet die Ansteuervorrichtung 12, aufgrund der Messwerte des Helligkeitssensors 13, bei abnehmender Helligkeit, je nach Bedarf, zumindest einen Emissionsbereich 11 hinzu.

Der Temperatursensor 14 misst die Betriebstemperatur von jedem der durch die Ansteuervorrichtung 12 betriebenen Emissionsbereich 11. Auch hierbei werden die entsprechend umgewandelten Temperaturmesswerte mittels einer weiteren Übertragungsleitung 141 an die Ansteuervorrichtung 12 übermittelt. In Abhängigkeit der Temperaturmesswerte kann die Ansteuervorrichtung 12 zumindest einen bisher betriebenen Emissionsbereich 11 dimmen oder deaktivieren.

Die Figuren 2 bis 4 zeigen in schematischen Draufsichten einzelne Ausführungsbeispiele eines hier beschriebenen strahlungsemittierenden Halbleiterchips 10.

Dabei weisen die in den Figuren 2a und 2b dargestellten strahlungsemittierenden Halbleiterchips 10 jeweils zwei Emissionsbereiche 11 auf, welche in der lateralen Richtung 101 voneinander beabstandet angeordnet sind.

In den Figuren 2c bis 2f weisen die strahlungsemittierenden Halbleiterchips 10 jeweils drei Emissionsbereiche 11 auf.

Aus den genannten Figuren ist erkennbar, dass zumindest ein Emissionsbereich 11 jeweils von zumindest einem übrigen Emissionsbereich 11 vollständig umrandet ist. Mit anderen Worten bildet der jeweils umrandete Emissionsbereich 11 einen zentralen Emissionsbereich 11 des Halbleiterchips 10, während die umrandenden Emissionsbereiche 11 zusammen zumindest einen Emissionsrandbereich des strahlungsemittierenden Halbleiterchips 10 bilden.

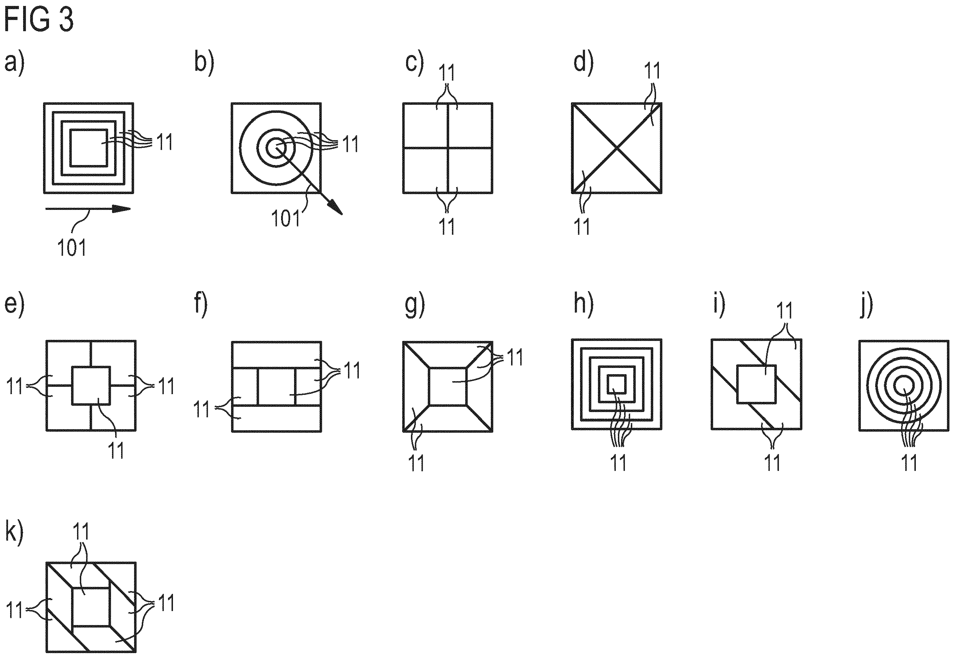

In den Figuren 3a bis 3d weisen die strahlungsemittierenden Halbleiterchips 10 jeweils vier Emissionsbereiche 11 und in den Figuren 3e bis 3j jeweils fünf Emissionsbereiche 11 auf.

Ferner weisen die strahlungsemittierenden Halbleiterchips 10 der Figur 3k sieben Emissionsbereiche 11, der Figuren 4a und 4b neun Emissionsbereiche 11, der Figur 4c dreizehn Emissionsbereiche 11 und der Figur 4d siebzehn Emissionsbereiche 11 auf.

Mit anderen Worten können die strahlungsemittierenden Halbleiterchips 10 je nach Bedarf vorgebbar angeordnete und jeweils geometrisch individuell ausgeformte Emissionsbereiche 11 aufweisen, sodass eine den jeweiligen Anforderungen an die Leuchtvorrichtung 100 gestellte Abstrahlcharakteristik realisiert werden kann.

In der Figur 5 ist in einer schematischen Schnittdarstellung ein hier beschriebener strahlungsemittierender Halbleiterchip 10 gezeigt, bei dem auf einem Träger 3, beispielsweise einem Substrat, zwei in lateraler Richtung 101 benachbarte Emissionsbereiche 11 epitaktisch abgeschieden sind. Erkennbar ist, dass die Emissionsbereiche 11 in lateraler Richtung 101 jeweils durch einen Zwischenbereich 111 beabstandet voneinander angeordnet sind. Mit anderen Worten sind die aktiven Zonen 2 der Emissionsbereiche 11 voneinander getrennt. Die aktiven Zonen 2 grenzen daher in lateraler Richtung 101 nicht direkt aneinander.

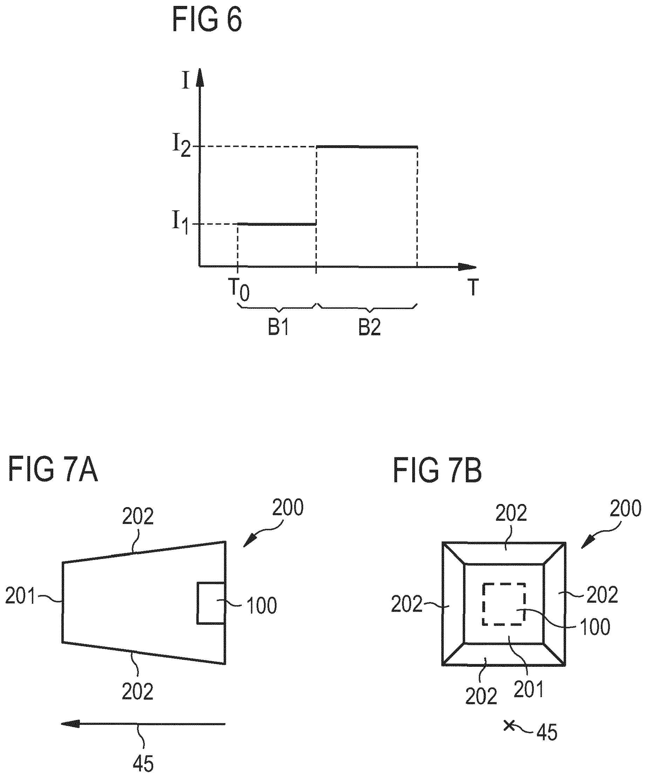

In der Figur 6 ist ein schematisches I-T-Diagramm verschiedener Betriebsmodi der Leuchtvorrichtung 100 dargestellt. In einem ersten Betriebsmodus B1 ist in dem Zeitabschnitt von einschließlich T₀ bis einschließlich T₁ nur ein von den übrigen Emissionsbereichen 11 umrandeter Emissionsbereich 11 von der Ansteuervorrichtung 12 betrieben. Die Leuchtvorrichtung 100 emittiert daher lediglich elektromagnetische Strahlung mit einer Intensität I₁. Zum Zeitpunkt T₁ schaltet die Ansteuervorrichtung 12 von außen vorgebbar von dem Betriebsmodus B1 in einen zweiten Betriebsmodus B2. In dem zweiten Betriebsmodus B2 werden alle Emissionsbereiche 11 von der Ansteuervorrichtung 12 betrieben. Das heißt, dass eine von der Leuchtvorrichtung 100 emittierte Intensität I₂ im zweiten Betriebsmodus größer ist als die Intensität I₁ während des ersten Betriebsmodus B1. Beispielsweise ist die Leuchtvorrichtung 100 ein Bremslicht, welches während der freien Fahrt, also ohne zu bremsen, sich im ersten Betriebsmodus B1 befindet und im Moment des Bremsens beispielsweise durch Betätigen des Bremspedals und/oder einer Bremsvorrichtung von dem Betriebsmodus B1 in den Bremsmodus, also in den Betriebsmodus B2, umschaltet. Beispielsweise ist dann die Intensität I₂ beim Bremsen zehn Mal höher als die Intensität I₁.

Die Figuren 7A und 7B zeigen in schematischen Seitenansichten eine hier beschriebene Signalleuchte 200. Die Signalleuchte 200 weist die Leuchtvorrichtung 100 auf. Die Leuchtvorrichtung 100 emittiert elektromagnetische Strahlung einer vorgebbaren Intensität in Richtung einer Projektionsfläche 201. Zum Beispiel ist die Projektionsfläche 201 mit einem Glas oder mit einem strahlungsdurchlässigen Kunststoff gebildet. Die aus der Leuchtvorrichtung 100 emittierte elektromagnetische Strahlung wird zumindest teilweise über die Projektionsfläche 201 aus der Signalleuchte 200 ausgekoppelt. Sowohl die Leuchtvorrichtung 100 als auch die Projektionsfläche 201 sind in einer Richtung quer zu einer Strahlungsaustrittsrichtung 45 der Leuchtvorrichtung 100 von zumindest einem Reflexionskörper 202 berandet, wobei der Reflexionskörper 202 auf ihn auftreffende elektromagnetische Strahlung zumindest teilweise in Richtung der Projektionsfläche 201 lenkt. Beispielsweise ist der Reflektionskörper 202 ein lichtleitendes Element oder zumindest ein Teil eines solchen. In diesem Fall kann es sich bei dem Reflektionskörper 202 um einen Lichtleiter oder um einen Teil eines Lichtleiters handeln.

In der Figur 7B ist die Signalleuchte 200 in Richtung ausgehend von der Projektionsfläche 201 hin zur Leuchtvorrichtung 200, also entgegen der Strahlungsaustrittsrichtung 45, gezeigt. Gestrichelt dargestellt ist wiederum die Leuchtvorrichtung 100, welche von der Projektionsfläche 201 verdeckt ist. Zum Beispiel handelt es sich bei der in den Figuren 7A und 7B beschriebenen Signalleuchte 200 um einen Kfz-Scheinwerfer, eine Leuchte, ein Kfz-Rücklicht oder um eine Leselicht.

Die Erfindung ist nicht durch die Beschreibung anhand der Ausführungsbeispiele beschränkt. Vielmehr erfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder dem Ausführungsbeispiel angegeben ist.

## Patentansprüche

1. Leuchtvorrichtung (100), umfassend
- zumindest einen strahlungsemittierenden Halbleiterchip (10) wobei der strahlungsemittierende Halbleiterchip zumindest zwei in lateraler Richtung (101) voneinander beabstandet angeordnete Emissionsbereiche (11) aufweist, wobei jeder Emissionsbereich (11) zumindest eine zur Emission von elektromagnetischer Strahlung geeignete aktive Zone (2) umfasst,
- eine Ansteuervorrichtung (12) zum Betreiben der Emissionsbereiche (11), wobei
- die Emissionsbereiche (11) getrennt voneinander elektrisch betreibbar sind, und
- die Ansteuervorrichtung (12) dazu eingerichtet ist, jeden Emissionsbereich (11) in Abhängigkeit von zumindest einer der folgenden Bedingungen getrennt von den verbleibenden Emissionsbereichen anzusteuern: Betriebsdauer des Emissionsbereichs (11), vorgebbare Mindestintensität der vom Emissionsbereich (11) emittierten elektromagnetischen Strahlung, Erreichen einer maximalen Betriebstemperatur des Halbleiterchips (10), Intensität der von dem Halbleiterchip (10) zu emittierenden elektromagnetischen Strahlung, Lichtstärkenverteilung entlang einer Leuchtfläche des strahlungsemittierenden Halbleiterchips, Lichtstärkenverteilung entlang eines von der Leuchtvorrichtung (100) zu beleuchtenden Objektes,
**dadurch gekennzeichnet dass**:
der strahlungsemittierende Halbleiterchip (10) zumindest einen Träger (3) umfasst, wobei zumindest zwei der Emissionsbereiche (11) gemeinsam auf dem Träger (3) epitaktisch aufgewachsen und befestigt sind, wobei die Emissionsbereiche (11)
eine oder mehrere der folgenden Eigenschaften aufweisen:
gleiche Ausdehnung in vertikaler Richtung, die gleiche Halbleiterschichtenfolge, eine gleiche Ausdehnung in vertikaler Richtung der einzelnen Halbleiterschichten, eine gleiche Materialzusammensetzung.

2. Leuchtvorrichtung (100) nach dem vorhergehenden Anspruch,
bei dem bei Unterschreiten einer Umgebungshelligkeit der Leuchtvorrichtung (100) die Ansteuervorrichtung (12) zumindest einen Emissionsbereich (11) hinzuschaltet oder bei Überschreiten einer Umgebungshelligkeit der Leuchtvorrichtung (100) zumindest einen Emissionsbereich abschaltet.

3. Leuchtvorrichtung (100) nach einem der vorhergehenden Ansprüche,
bei dem die Ansteuervorrichtung (12) dazu eingerichtet ist, ein nach Erreichen zumindest einer der Bedingungen für einen von der Ansteuervorrichtung (12) betriebenen Emissionsbereich (11), den Emissionsbereich (11) zu dimmen oder zu deaktivieren.

4. Leuchtvorrichtung (100)nach einem der vorhergehenden Ansprüche,
bei dem die Zahl der sich in Betrieb befindlichen Emissionsbereiche (11) während des Betriebs der Leuchtvorrichtung (100) konstant ist.

5. Leuchtvorrichtung (100) nach einem der vorhergehenden Ansprüche,
bei dem bei Unterschreiten einer Mindestintensität der von dem Halbleiterchip (10) emittierten elektromagnetischen Strahlung die Ansteuervorrichtung (12) zumindest einen Emissionsbereich (11) hinzuschaltet.

6. Leuchtvorrichtung (100) nach einem der vorhergehenden Ansprüche,
bei dem die von dem Halbleiterchip (10) emittierte Intensität während des Betriebs der Leuchtvorrichtung (100) durch die Ansteuervorrichtung konstant gehalten wird.

7. Leuchtvorrichtung (100) nach einem der vorhergehenden Ansprüche,
bei dem zumindest ein Emissionsbereich (11) von den übrigen Emissionsbereichen (11) zumindest stellenweise umrandet ist, wobei in einem ersten Betriebsmodus (B1) der Leuchtvorrichtung (100) nur der umrandete Emissionsbereich (11) von der Ansteuervorrichtung (12) betrieben wird und in einem zweiten Betriebsmodus (B2) zumindest einer der übrigen Emissionsbereiche (11) betrieben wird.

8. Leuchtvorrichtung (100) nach dem vorhergehenden Anspruch,
bei dem im zweiten Betriebsmodus (B2) nur die übrigen Emissionsbereiche (11) von der Ansteuervorrichtung (12) betrieben werden.

9. Leuchtvorrichtung (100) nach Anspruch 7,
bei dem im zweiten Betriebsmodus (B2) alle Emissionsbereiche (11) von der Ansteuerschaltung (12) betrieben werden.

10. Leuchtvorrichtung (100) nach einem der Ansprüche 7 bis 9,
bei dem die Intensität der von dem Halbleiterchip (10) emittierten elektromagnetischen Strahlung im zweiten Betriebsmodus (B2) wenigstens fünf Mal und höchstens fünfzehn Mal so hoch ist wie im ersten Betriebsmodus (B1) ist.

11. Leuchtvorrichtung (100) nach einem der Ansprüche 7 bis 9,
bei dem die Intensität der von dem Halbleiterchip (10) emittierten elektromagnetischen Strahlung im ersten Betriebsmodus (B1) wenigstens fünf Mal und höchstens fünfzehn Mal so hoch ist wie im zweiten Betriebsmodus (B2) .

12. Signalleuchte (200), mit
- zumindest einer Leuchtvorrichtung (100) nach einem der vorhergehenden Ansprüche, und
- zumindest einer Projektionsfläche (201), auf welche die aus der Leuchtvorrichtung (100) ausgekoppelte elektromagnetische Strahlung trifft und die von der Leuchtvorrichtung (100) ausgekoppelte elektromagnetische Strahlung zumindest teilweise über die Projektionsfläche (201) aus der Signalleuchte (200) auskoppelt.

13. Verwendung einer Signalleuchte (200) nach Anspruch 12 als Lichtquelle in einem Kfz-Scheinwerfer, einem Kfz-Rücklicht oder einem Leselicht.

## Claims

1. Illuminating device (100) comprising
- at least one radiation-emitting semiconductor chip (10), wherein the radiation-emitting semiconductor chip (10) has at least two emission regions (11) arranged at a distance from one another in a lateral direction (101), wherein each emission region (11) comprises at least one active zone (2) suitable for emitting electromagnetic radiation;
- a control device (12) for operating the emission regions (11), wherein
- the emission regions (11) can be operated separately from one another, and
- the control device (12) is set up to control each emission region (11) separately from the remaining emission regions depending on at least one of the following conditions:
operating time of the emission region (11), specifiable minimum intensity of the electromagnetic radiation emitted by the emission region (11), reaching a maximum operating temperature of the semiconductor chip (10), intensity of the electromagnetic radiation to be emitted by the semiconductor chip (10), luminous intensity distribution along a luminous surface of the radiation-emitting semiconductor chip, luminous intensity distribution along an object to be illuminated by the illuminating device (100), **characterized in that**:
the radiation-emitting semiconductor chip (10) comprises at least one carrier (3), wherein at least two of the emission regions (11) are epitaxially grown together on the carrier (3) and fixed to the carrier (3), wherein the emission regions (11) have one or more of the following properties:
same expansion in vertical direction, same semiconductor layer sequence, same expansion in vertical direction of the individual semiconductor layers, same material composition.

2. Illuminating device (100) according to the preceding claim,
in which the control device (12) switches on at least one emission region (11) when an ambient brightness of the illuminating device (100) is not reached or switches off at least one emission region when an ambient brightness of the illuminating device (100) is exceeded.

3. Illuminating device (100) according to any of the preceding claims,
in which, after at least one of the conditions for an emission region (11) operated by the control device (12) has been reached ,the control device (12) is set up to dim or deactivate the emission region (11).

4. Illuminating device (100) according to any of the preceding claims,
wherein the number of emission regions (11) in operation is constant during operation of the illuminating device (100).

5. Illuminating device (100) according to any of the preceding claims,
in which, when the electromagnetic radiation emitted by the semiconductor chip (10) falls below a minimum intensity, the control device (12) switches on at least one emission range (11) .

6. Illuminating device (100) according to any of the preceding claims, in which the intensity emitted by the semiconductor chip (10) is kept constant by the control device during operation of the illuminating device (100).

7. Illuminating device (100) according to any of the preceding claims,
in which at least one emission region (11) is at least partially bordered by the remaining emission regions (11), wherein, in a first operating mode (B1) of the illuminating device (100), only the bordered emission region (11) is operated by the control device (12) and, in a second operating mode (B2), at least one of the remaining emission regions (11) is operated.

8. Illuminating device(100) according to the preceding claim,
in which in the second operating mode (B2) only the remaining emission regions (11) are operated by the control device (12) .

9. Illuminating device (100) according to claim 7,
in which in the second operating mode (B2) all emission regions (11) are operated by the control device (12).

10. Illuminating device (100) according to any of claims 7 to 9,
in which the intensity of the electromagnetic radiation emitted by the semiconductor chip (10) in the second operating mode (B2) is at least five times and at most fifteen times as high as in the first operating mode (B1).

11. Illuminating device (100) according to any one of claims 7 to 9,
in which the intensity of the electromagnetic radiation emitted by the semiconductor chip (10) in the first operating mode (B1) is at least five times and at most fifteen times as high as in the second operating mode (B2).

12. Signal lamp (200), with
- at least one illuminating device (100) according to any of the preceding claims, and
- at least one projection surface (201), which the electromagnetic radiation coupled out of the illuminating device (100) hits and the electromagnetic radiation coupled out by the illuminating device (100) is at least partially coupled out of the signal lamp (200) via the projection surface (201).

13. Using a signal lamp (200) according to claim 12 as a light source in a vehicle headlamp, vehicle taillight or reading light.

## Revendications

1. Dispositif d'éclairage (100) comprenant
- au moins une puce semi-conductrice émettrice de rayonnement (10), la puce semi-conductrice émettrice de rayonnement ayant au moins deux zones d'émission (11) disposées à distance l'une de l'autre en direction latérale (101), chaque zone d'émission (11) comprenant au moins une zone active (2) adaptée pour l'émission d'un rayonnement électromagnétique,
- un dispositif de commande (12) pour l'exploitation des zones d'émission (11),
- les zones d'émission (11) pouvant être exploitées séparément l'une de l'autre par commande électrique, et
- le dispositif de commande (12) étant configuré pour commander chaque zone d'émission (11) séparément des autres zones d'émission en fonction d'au moins une des conditions suivantes : durée de fonctionnement de la zone d'émission (11), intensité minimale prédéfinissable du rayonnement électromagnétique émis par la zone d'émission (11), atteinte d'une température de fonctionnement maximale de la puce semi-conductrice (10), intensité du rayonnement électromagnétique devant être émis par la puce semi-conductrice (10), répartition de l'intensité lumineuse le long d'une surface lumineuse de la puce semi-conductrice émettrice de rayonnement, répartition de l'intensité lumineuse le long d'un objet devant être éclairé par le dispositif d'éclairage (100),
**caractérisé en ce que** :
la puce semi-conductrice émettrice de rayonnement (10) comprend au moins un support (3), sur lequel au moins deux des zones d'émission (11) sont formées par croissance épitaxiale et fixées ensemble sur le support (3), les zones d'émission (11) ayant une ou plusieurs des propriétés suivantes: même expansion verticale, même succession de couches semi-conductrices, même expansion verticale des couches semi-conductrices individuelles, même composition de matériau.

2. Dispositif d'éclairage (100) selon la revendication précédente,
dans lequel le dispositif de commande (12) active au moins une zone d'émission (11) lorsqu'une luminosité ambiante du dispositif d'éclairage (100) n'est pas atteinte ou désactive au moins une zone d'émission lorsqu'une luminosité ambiante du dispositif d'éclairage (100) est excédée.

3. Dispositif d'éclairage (100) selon l'une des revendications précédentes,
dans lequel le dispositif de commande (12) est configuré pour atténuer ou désactiver la zone d'émission (11) après l'atteinte d'au moins l'une des conditions pour une zone d'émission (11) actionnée par le dispositif de commande (12).

4. Dispositif d'éclairage (100) selon l'une des revendications précédentes,
dans lequel le nombre de zones d'émission (11) en fonctionnement est constant pendant le fonctionnement du dispositif d'éclairage (100).

5. Dispositif d'éclairage (100) selon l'une des revendications précédentes,
dans lequel le dispositif de commande (12) active au moins une zone d'émission (11) lorsque le rayonnement électromagnétique émis par la puce semi-conductrice (10) devient inférieur à une intensité minimale.

6. Dispositif d'éclairage (100) selon l'une des revendications précédentes,
dans lequel l'intensité émise par la puce semi-conductrice (10) est maintenue constante par le dispositif de commande pendant le fonctionnement du dispositif d'éclairage (100).

7. Dispositif d'éclairage (100) selon l'une des revendications précédentes,
dans lequel au moins une zone d'émission (11) est au moins partiellement bordée des zones d'émission (11) restantes, seule la zone d'émission bordée (11) étant actionnée par le dispositif de commande (12) dans un premier mode de fonctionnement (Bl) du dispositif d'éclairage (100) et au moins l'une des zones d'émission (11) restantes étant actionnée dans un second mode de fonctionnement (B2).

8. Dispositif d'éclairage (100) selon la revendication précédente,
dans lequel seules les zones d'émission (11) restantes sont actionnées par le dispositif de commande (12) dans le deuxième mode de fonctionnement (B2).

9. Dispositif d'éclairage (100) selon la revendication 7,
dans lequel toutes les zones d'émission (11) sont commandées par le circuit de commande (12) dans le deuxième mode de fonctionnement (B2).

10. Dispositif d'éclairage (100) selon l'une des revendications 7 à 9,
dans lequel l'intensité du rayonnement électromagnétique émis par la puce semi-conductrice (10) dans le deuxième mode de fonctionnement (B2) est au moins cinq fois et au plus quinze fois plus élevée que dans le premier mode de fonctionnement (Bl) .

11. Dispositif d'éclairage (100) selon l'une des revendications 7 à 9,
dans lequel l'intensité du rayonnement électromagnétique émis par la puce semi-conductrice (10) dans le premier mode de fonctionnement (Bl) est au moins cinq fois et au plus quinze fois plus élevée que dans le second mode de fonctionnement (B2) .

12. Feu de signalisation (200) avec
- au moins un dispositif d'éclairage (100) selon l'une des revendications précédentes,
- au moins une surface de projection (201) atteinte par le rayonnement électromagnétique découplé du dispositif d'éclairage (100) et sur laquelle le rayonnement électromagnétique découplé du dispositif d'éclairage (100) est au moins partiellement découplé du feu de signalisation (200) par le biais de la surface de projection (201).

13. Utilisation d'un feu de signalisation (200) selon la revendication 12 comme source lumineuse dans un phare de voiture, un feu arrière de voiture ou une lampe de lecture.
